Europäisches Patentamt

European Patent Office

Office européen des brevets

(19)

(11) EP 0 616 428 B1

(12) **FASCICULE DE BREVET EUROPEEN**

(45) Date de publication et mention
de la délivrance du brevet:
**02.10.1996 Bulletin 1996/40**

(51) Int Cl.[6]: **H03K 3/537**

(21) Numéro de dépôt: **94400462.1**

(22) Date de dépôt: **04.03.1994**

(54) **Générateur de Marx**

Marx-Generator

Marx generator

(84) Etats contractants désignés:
**DE GB**

(30) Priorité: **18.03.1993 FR 9303116**

(43) Date de publication de la demande:
**21.09.1994 Bulletin 1994/38**

(73) Titulaire: **ETAT FRANCAIS,
Représenté par le Délégué Général, pour
l'Armement
Paris 7ème (FR)**

(72) Inventeurs:
• **Leon, Jean-François
F-46120 Le Bourg (FR)**
• **Auvray Philippe
F-91510 Lardy (FR)**
• **Etlicher, Bernard
F-91470 Les Molières (FR)**
• **Lamain, Henri
F-92140 Clamart (FR)**

(56) Documents cités:
**US-A- 3 845 322**

• **JOURNAL OF SCIENTIFIC INSTRUMENTS, vol.1,
1 Juin 1968, LONDON,GB pages 688 - 689 G.
BAUER ET. AL. 'a low impedance high voltage
nanosecond pulser'**
• **IEEE Conference Record of the 1980 Fourteenth
Pulse Power Modulator Conference Symposium,
USA, 3-5 June 1980, Pages 201-208, M. Obara,
"Strip-Line
Multichannel-Surface-Spark-Gap-Type Marx
Generator for Fast Discharge Lasers"**

EP 0 616 428 B1

## Description

L'invention se rapporte à un générateur de Marx et concerne plus spécifiquement le domaine des générateurs de Marx susceptibles de stocker et de restituer des énergies de l'ordre de 100 kj à plusieurs mégajoules.

On sait qu'un générateur de Marx est un générateur de haute tension impulsionnelle, dont la fonction essentielle est de stocker de l'énergie électrique puis de la restituer sous forme d'une impulsion de grande puissance et de haute tension. Il est constitué essentiellement par un ensemble de condensateurs connectés entre eux de manière à pouvoir être chargés en parallèle et déchargés en série. Un circuit d'alimentation assure la charge en parallèle des condensateurs, qui, reliés en série via des éclateurs, se déchargent en série, lorsque ces derniers sont activés, sur une charge connectée entre les deux bornes de sortie du générateur.

Un générateur de Marx se caractérise essentiellement par trois paramètres électriques :

- l'énergie W qu'il est capable de stocker ;
- sa tension de sortie Vs, c'est-à-dire la tension de crête maximale de l'impulsion de sortie qu'il peut délivrer ;
- le temps de montée de cette impulsion, qui correspond au quart de la période du générateur de Marx oscillant sur lui-même lorsqu'on le fait fonctionner en ayant court-circuité ses bornes de sortie. Ce quart de période a pour expression:

$$tq = \frac{\pi}{2\,Vs}\sqrt{2\,WL}$$

où L est l'inductance totale du générateur.

Cette formule précise une loi de comportement importante et générale pour ce type de système électrique, à savoir que, si on veut construire des générateurs de Marx qui minimisent le quart de période pour une énergie stockée donnée, il faut :

- soit augmenter la tension Vs,
- soit diminuer l'inductance L du système.

On constate, à l'examen des caractéristiques de quelques générateurs de Marx existants tel le générateur de Marx divulgué dans le brevet US 3845322, que leur inconvénient fondamental réside dans le fait que des impulsions énergétiques à faible temps de montée ne peuvent être obtenues que par le biais d'une tension Vs élevée (supérieure à 700 kV en pratique). Dans certains cas, cette contrainte de tension élevée n'est justifiée que par une exigence de rapidité et pénalise les performances des systèmes utilisant ces générateurs de Marx en imposant un accroissement des distances entre les différents conducteurs et une augmentation importante de la qualité des diélectriques employés. De plus, une augmentation de la tension de service d'un générateur de Marx induit inévitablement une augmentation de son inductance en imposant une augmentation des distances entre les conducteurs. Enfin, les coûts d'entretien de tels systèmes augmentent significativement avec leurs tensions de travail.

L'article de Monsieur OBARA et al divulgué lors du 14ème symposium de 1980 sur les modulateurs de puissance à impulsion aux Etats-Unis divulgue un générateur de Marx qui permet de réduire le temps de montée des impulsions délivrées par abaissement de son inductance.

Ce générateur de Marx présente des condensateurs connectés en série par une ligne plate formée de deux bandes métalliques s'étendant en regard l'une de l'autre, parallèlement à un même plan et suivant une même direction longitudinale, ces bandes étant reliées électriquement entre elles, une première bande étant continue et une deuxième bande divisée par des fentes transversales en tronçons successifs plans interconnectés en série alternativement par un condensateur et un éclateur.

Une ligne d'interconnexion des condensateurs dotée de cette structure apporte une très faible inductance en plus de l'inductance propre de chaque condensateur, ce qui réduit la valeur de la quantité tq, donc du temps de montée des impulsions de sortie, et permet de multiplier le nombre d'étages en série du générateur, chaque étage correspondant à un condensateur.

Les tronçons précités, séparés par une fente où est interposé un éclateur, sont disposés dans un même plan et chaque éclateur est un éclateur de surface qui, lorsqu'il est activé, crée dans la fente, entre les deux tronçons, une zone conductrice plane située dans le même plan que ceux-ci.

Un éclateur de ce type présente la particularité de donner naissance entre les deux tronçons où il est disposé, sur commande d'activation, à une nappe conductrice d'arcs électriques qui assure une continuité non seulement électrique, mais aussi géométrique, d'un tronçon à l'autre, de sorte que l'inductance qu'il introduit est minimisée.

La présente invention a pour but de proposer un générateur de Marx présentant un temps de montée des impulsions réduit par abaissement de son inductance, dans lequel l'éclateur s'intègre dans la bande de ligne plate sur laquelle il est monté.

L'invention a pour objet un générateur de Marx, comprenant plusieurs condensateurs connectés en série, via des éclateurs, entre deux bornes de sortie et un circuit d'alimentation assurant la charge en parallèle des condensateurs, tel que la connexion en série des condensateurs est assurée par une ligne plate formée de deux bandes métalliques s'étendant en regard l'une de l'autre, parallèlement à un même plan et suivant une même direction longitudinale, ces bandes étant reliées électriquement entre elles à l'une des extrémités de la ligne et respectivement aux bornes de sortie à l'autre extrémité et comprenant une première bande continue et une deuxième bande divisée par des fentes transversales en tronçons successifs disposés dans un même plan interconnectés en série alternativement par un condensateur et par un éclateur qui, lorsqu'il est activé, crée dans la fente, entre les deux tronçons, une zone conductrice plane située dans le même plan que ceux-ci, générateur caractérisé par le fait que chaque éclateur comprend une électrode métallique d'activation disposée en regard de la fente et offrant une surface parallèle au plan et de dimensions voisines de celles de la fente, ainsi qu'une feuille isolante formant une entretoise interposée entre l'électrode d'activation et les bords des tronçons.

Par ailleurs, il convient que l'écartement entre chaque paire de tronçons de la deuxième bande réunis par un éclateur et la première bande soit fixé en fonction du niveau de la différence de potentiel qui apparaît entre cette paire de tronçons et la première bande lorsque les éclateurs sont activés et mis à l'état de conduction. Ainsi, l'épaisseur de la ligne diffère d'un étage à l'autre du générateur, étant calculée au plus juste pour minimiser l'inductance de chaque étage. Cette disposition pourra en pratique être réalisée en donnant à la deuxième bande de la ligne (où sont interposés les condensateurs et les éclateurs) la forme d'un escalier, la première bande étant plane.

En conclusion, on peut dire que l'invention permet de concevoir et de construire des générateurs de Marx stockant de grandes quantités d'énergie et présentant une inductance très faible. Pour une tension Vs modérée (Vs < 700 kV typiquement), le quart de période du générateur reste proche du quart de période des condensateurs choisis pour réaliser le montage. Le nombre d'étages en série du générateur influe peu sur le temps de montée de l'impulsion délivrée dans un court-circuit.

D'autres particularités et avantages de l'invention ressortiront de la description qui va suivre, en regard des dessins annexés, d'un exemple de réalisation non limitatif.

La figure 1 représente schématiquement, en coupe longitudinale, un générateur de Marx selon l'invention.

La figure 2 représente, en vue de dessus avec un léger effet de perspective, la ligne de connexion du générateur de la figure 1 dont les condensateurs et les éclateurs ont été omis.

La figure 3 représente en perspective une vue simplifiée de l'un des étages du générateur de la figure 1.

La figure 4 représente, à plus grande échelle, l'un des éclateurs du générateur de la figure 1.

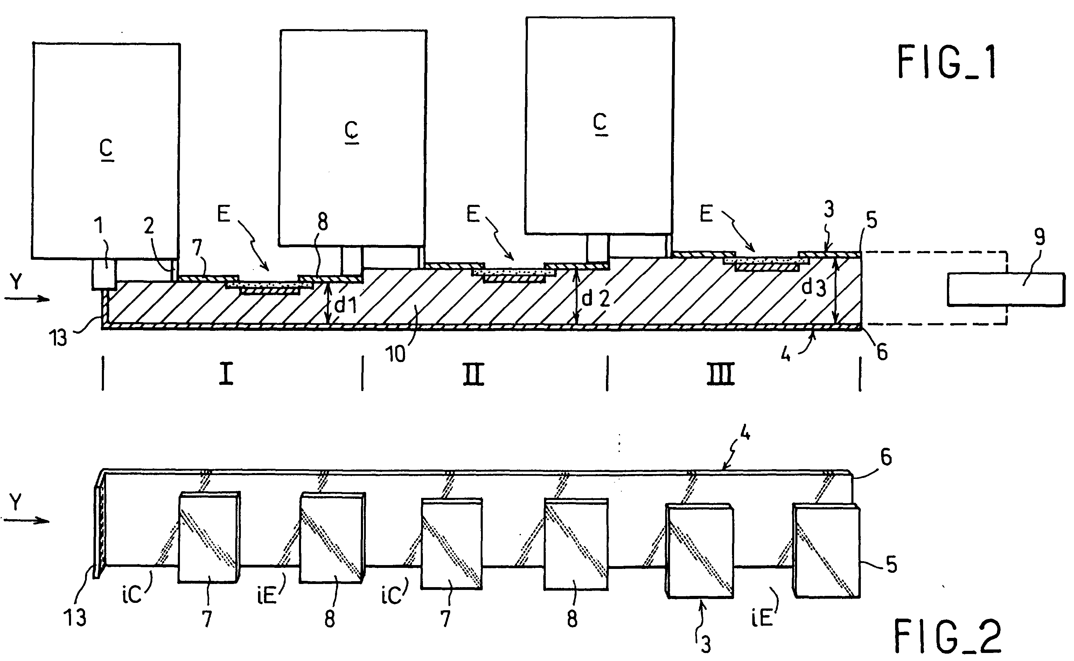

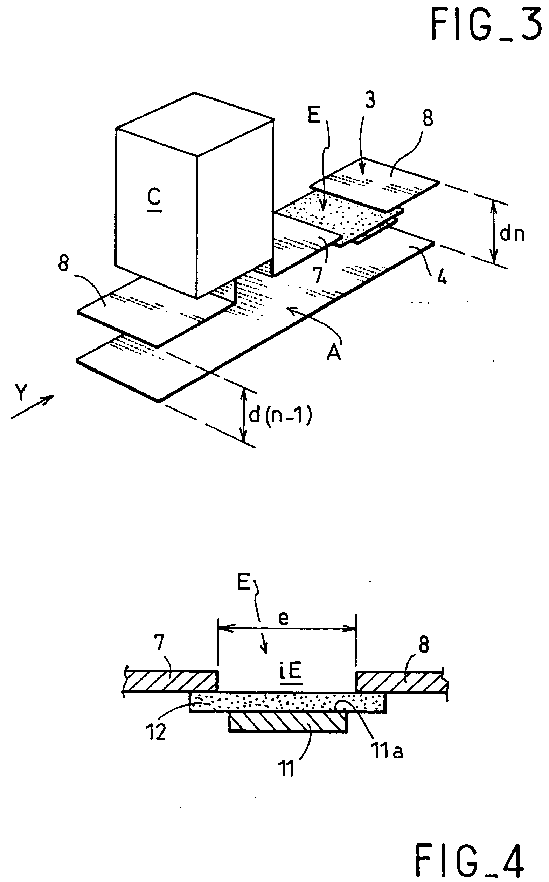

Le générateur de Marx représenté à la figure 1 comprend trois étages I, II, III, chacun d'eux étant équipé d'un condensateur C, contenu dans un boîtier parallélépipédique (figure 3) et offrant ses deux bornes de connexion 1, 2 sur une même face de ce boîtier. Les trois condensateurs C sont reliés électriquement en série par l'une des bandes d'une ligne plate formée de deux bandes parallèles 3, 4 s'étendant suivant une même direction longitudinale Y. A cet effet, la bande supérieure 3 est interrompue par trois intervalles iC successifs (figure 2), les bords de la bande limitant chacun de ces intervalles étant respectivement reliés aux bornes de l'un des condensateurs C. Les éléments de la bande 3 allant de la borne 2 d'un condensateur à la borne 1 du condensateur suivant ou, pour le dernier étage III, à la borne de sortie 5 de la bande 3 sont eux-mêmes divisés en deux tronçons 7, 8 situés dans un même plan et séparés par un intervalle iE dans lequel est disposé un éclateur E destiné à mettre en liaison électrique, sur commande, ces deux tronçons 7, 8. La bande inférieure 4, qui est maintenue au potentiel de la masse, s'étend sans interruption sur la même longueur que la bande supérieure 3 divisée en tronçons 7, 8 successifs, et se termine par une borne de sortie 6 en regard de la borne de sortie 5 de la bande 3; c'est à ces bornes 5, 6 qu'est connectée la charge 9 sur laquelle doit débiter le générateur de Marx. Quant aux extrémités opposées de la ligne plate, elles sont court-circuitées par une connexion 13.

L'espace A compris entre les bandes 3 et 4 de la ligne est rempli d'une substance 10 de forte rigidité diélectrique (par exemple 350 kV/cm); qu'elle soit solide, liquide ou gazeuse, elle doit être capable d'assurer l'isolement électrique nécessaire entre les deux bandes dans la phase de décharge du générateur de Marx, dans laquelle les condensateurs C, préalablement chargés en parallèle à une tension V grâce à un circuit de charge non représenté, sont déchargés en série par la mise en activité des éclateurs E, qui, devenant alors conducteurs, établissent la continuité de la bande 3 entre chaque condensateur et le condensateur suivant sur la borne de sortie 5.

Au moment de la décharge des condensateurs en série, les tronçons 7 et 8 de l'étage I se trouvent portés à la tension V, ceux de l'étage II à la tension 2V et ceux de l'étage III à la tension 3V par rapport à la bande de masse 4. En conséquence, il convient de donner à l'espacement des paires de tronçons 7, 8 de la bande 3 par rapport à la bande 4 des valeurs d1, d2, d3 (ou, pour un nombre d'étages quelconque, ... d(n-1), dn, d(n+1) ...) allant de même en croissant, comme le montrent les figures 1 et 3. La bande supérieure 3 a pour cette raison, dans le présent exemple, la forme d'un escalier dont les marches sont formées par les paires de tronçons 7, 8 et qui va en montant de l'extrémité en court-circuit de la ligne vers les bornes de sortie 5, 6, tandis que la bande inférieure 4 est plane (cf figure 1).

Comme le montre la figure 4, un éclateur E comprend une électrode de déclenchement 11 et une feuille diélectrique rigide 12 (par exemple en polyéthylène). L'électrode 11 présente une surface plane 11a ayant un pourtour rectangulaire de dimensions voisines de celles de l'intervalle iE où est disposé l'éclateur. Cette surface est maintenue parallèle au plan des tronçons 7 et 8 limitant ledit intervalle, et à faible distance de ceux-ci, par la feuille diélectrique 12, interposée entre l'électrode 11 et les tronçons 7 et 8 sur les bords desquels elle prend appui. La valeur de la largeur e de l'intervalle iE est choisie en fonction de la tension V de charge de chacun des condensateurs C.

Un éclateur E se comporte comme un interrupteur connecté entre les tronçons 7 et 8. Lorsqu'on applique à l'électrode de déclenchement 11 une tension suffisante, il y a création d'un grand nombre d'arcs électriques entre les bords en regard des tronçons 7 et 8, qui autorise le passage d'un courant entre ces derniers, ce qui correspond à la fermeture de l'interrupteur. Un tel éclateur a une action "de surface", localisée dans le plan commun des tronçons 7, 8 entre lesquels il est interposé, de sorte que, lorsqu'il est activé, il les réunit par une liaison contenue dans ce plan. Par suite, l'inductance introduite dans la bande 3 de la ligne plate par chacun des éclateurs E se trouve minimisée.

Pour faire fonctionner le générateur de Marx, on procède tout d'abord à la charge des condensateurs en parallèle à la tension V grâce au circuit annexe de charge mentionné plus haut. Puis, lorsque les condensateurs sont pleinement chargés, on excite simultanément les éclateurs E par application, grâce à un autre circuit annexe non représenté, d'une tension convenable à leurs électrodes de déclenchement 11. Ils se comportent alors comme des interrupteurs fermés, de sorte que les condensateurs C se déchargent en série, via la ligne plate, dans la charge 9, laquelle reçoit une impulsion de tension élevée dont la valeur peut aller jusqu'à NV, N étant le nombre d'étages du générateur, mais dont la valeur réelle dépend des caractéristiques de la charge.

Si la charge 9 est court-circuitée, la durée de cette impulsion est directement liée à la quantité $t_q$ qui est le quart de la période du circuit oscillant constitué par la capacité des condensateurs C et l'inductance de la ligne augmentée de l'inductance propre des condensateurs. Cette quantité $t_q$ a pour expression, comme on l'a vu plus haut :

$$tq = \frac{\pi}{2Vs}\sqrt{2WL}$$

Pour réduire la valeur de la quantité $t_q$, on peut soit augmenter le produit N x V, soit diminuer l'inductance totale L du système.

L'utilisation d'une ligne plate décrite dans le présent exemple permet de réduire l'inductance L, ou plus précisément l'inductance introduite par chacun des étages en plus de celle du condensateur C. Par suite, l'adjonction d'étages supplémentaires ne cause qu'une faible augmentation de l'inductance totale.

Ce point a été mis en évidence grâce à l'expérience qui va maintenant être décrite.

On a réalisé un générateur de Marx à trois étages conforme à la description précédente, en utilisant des condensateurs de 0,1 µF, 50 kV (présentant une inductance intrinsèque de 20 nH), qui sont chargés en parallèle à une tension V = 22 kV. Chacun des trois éclateurs de surface E, monté dans un intervalle iE de largeur égale à 25 mm, est commandé par un même générateur de déclenchement pouvant délivrer une tension de l'ordre de 30 kV.

On a ainsi obtenu des impulsions de 27 kA sous 66 kV, de période égale à 360 ns. Ces résultats permettent de calculer l'inductance totale L à l'aide de la formule indiquée plus haut, qui peut s'écrire :

$$L = (t_q / \pi)^2 (1 / Cglob),$$

Cglob étant la capacité globale du générateur de Marx (égale au tiers de la capacité de chacun des trois condensateurs C). Remplaçant les lettres par leurs valeurs numériques, on trouve que la valeur de L est très voisine de 100 nH.

Si on reprend l'expérience avec un générateur limité à un seul étage, mais avec une ligne identique, on obtient une impulsion de sortie ayant une période très peu différente de la précédente.

On voit que, le générateur à trois étages conduisant à peu près à la même période que celui à un étage, l'ajout d'étages supplémentaires n'introduit guère d'inductance parasite.

On peut donc envisager la construction de générateurs de Marx à N étages pour lesquels le quart de période varie peu pour des tensions Vs modérées (Vs = 700 kV), mais dont l'énergie croît proportionnellement au nombre d'étages.

**Revendications**

1. Générateur de Marx, comprenant plusieurs condensateurs connectés en série, via des éclateurs, entre deux bornes de sortie et un circuit d'alimentation assurant la charge en parallèle des condensateurs, tel que la connexion en série des condensateurs (C) est assurée par une ligne plate formée de deux bandes métalliques (3, 4) s'étendant en regard l'une et l'autre, parallèlement à un même plan et suivant une même direction longitudinale (Y), ces bandes étant reliées électriquement entre elles à l'une des extrémités de la ligne et respectivement aux bornes de sortie (5, 6) à l'autre extrémité et comprenant une première bande continue (4) et une deuxième bande (3) divisée par des fentes transversales (iC, iE) en tronçons successifs (7, 8, 7, 8, ...) disposés dans un même plan interconnectés en série alternativement par un condensateur et par un éclateur (E), qui, lorsqu'il est activé, crée dans la fente, entre les deux tronçons, une zone conductrice plane située dans le même plan que ceux-ci,
   caractérisé par le fait que chaque éclateur (E) comprend une électrode métallique d'activation (11) disposée en regard de la fente (iE) et offrant une surface (11a) parallèle au plan et de dimensions voisines de celles de la fente, ainsi qu'une feuille isolante (12) formant une entretoise interposée entre l'électrode d'activation (11) et les bords des tronçons (7, 8).

2. Générateur selon la revendication 1, caractérisé par le fait que l'écartement (dn) entre chaque paire de tronçons (7, 8) de la deuxième bande (3) réunis par un éclateur (E) et la première bande (4) est fixé en fonction du niveau de la différence de potentiel qui apparaît entre cette paire de tronçons et la première bande lorsque les éclateurs (E) sont activés et mis à l'état de conduction.

3. Générateur selon la revendication 2, caractérisé par le fait que la première bande (4) est plane, la deuxième bande (3) offrant la forme d'un escalier.

**Patentansprüche**

1. Marx-Generator mit mehreren seriell über Funkenstrecken verbundenen Kondensatoren zwischen zwei Ausgangsklemmen und einer Versorgungsleitung, welcher die parallele Ladung der Kondensatoren gewährleistet, so daß die serielle Verbindung der Kondensatoren (C) durch eine aus zwei sich gegenüberliegenden, parallel zur selben Ebene und gemäß derselben Längsrichtung (Y) verlaufenden Metallstreifen (3, 4) gebildete flache Leitung gewährleistet ist, wobei die Streifen an einem Ende der Leitung und jeweils an den Ausgangsklemmen (5, 6) am anderen Ende elektrisch miteinander verbunden sind, einschließlich einem ersten ununterbrochenen Streifen (4) und einem zweiten Streifen (3), der durch Querschlitze (iC, iE) in aufeinanderfolgende, auf gleicher Ebene angeordnete Abschnitte (7, 8, 7, 8, ...) getrennt ist, welche wechselweise über einen Kondensator und eine Funkenstrecke (E), welche nach dem Aktivieren im Schlitz zwischen den beiden Abschnitten eine auf gleicher Ebene liegende flache Leitzone bildet, seriell verbunden sind, dadurch gekennzeichnet, daß jede Funkenstrecke (E) eine dem Schlitz (iE) gegenüberliegende, metallische Aktivierungselektrode (11) enthält, welche eine parallel zur Ebene liegende Oberfläche (11a) mit den Abmessungen des Schlitzes ähnlichen Abmessungen bietet, sowie eine Isolierfolie (12), welche ein zwischen der Aktivierungselektrode (11) und den Kanten der Abschnitte (7, 8) zwischengeschaltetes Distanzstück bildet.

2. Generator gemäß Patentanspruch 1, dadurch gekennzeichnet, daß der Abstand (dn) zwischen jedem durch eine Funkenstrecke (E) verbundenen Abschnittpaar (7, 8) des zweiten Streifens (3) und dem ersten Streifen (4) entsprechend dem Niveau der Potentialdifferenz, welche zwischen diesem Abschnittpaar und dem ersten Streifen auftritt, wenn die Funkenstrecken (E) aktiviert und in Leitzustand versetzt sind, festgelegt ist.

3. Generator gemäß Patentanspruch 2, dadurch gekennzeichnet, daß der erste Streifen (4) flach und der zweite Streifen (3) treppenförmig verläuft.

**Claims**

1. Marx generator, comprising a number of capacitors connected in series through spark gaps, between two output terminals and a power supply circuit which charges the said capacitors in parallel, the series connection of the capacitors (C) consisting of a flat line formed of two metal strips (3, 4) running facing one another, parallel to the same plane and in the same longitudinal direction (Y), these strips being connected together electrically at one end of the line and respectively to the output terminals (5, 6) at the other end and consisting of one continuous strip (4) and a second strip (3) subdivided by transverse slots (iC, iE) into successive plane sections (7, 8, 7, 8,...) interconnected in series, alternately by a capacitor and a spark gap (E), which, when actuated, creates in the said slot, between the two sections, a plane conducting zone in the same plane as the said sections, characterised by the fact that each spark gap (E) comprises a metal actuation electrode (11) placed opposite the said slot (iE) and having a surface (11a) parallel to the said plane and dimensions similar to those of the slot, together with an insulating sheet (12) forming a spacer between the actuation electrode (11) and the edges of the said sections (7, 8).

2. Generator according to claim 1, characterised by the fact that the distance (dn) between each pair of sections (7, 8) on the second strip (3) linked by a spark gap (E) and the first strip (4) is fixed as a function of the potential difference that appears between this pair of sections and the first strip when the spark gaps (E) are actuated and rendered conducting.

3. Generator according to claim 2, characterised by the fact that the first strip (4) is flat, the second strip (3) being in the shape of a staircase.

EP 0 616 428 B1

FIG_1

Y →

C    C    C

E    E    E

1  2  7  8    3  5  9

13    d1    d2    d3    4  6

10

I    II    III

Y →

4    6

13  iC  7  iE  8  iC  7  8  3  iE  5

FIG_2

FIG_3

FIG_4